# EUROPÄISCHE PATENTSCHRIFT

(11) **EP 1 759 452 B1**
(45) Veröffentlichungstag und Bekanntmachung des Hinweises auf die Patenterteilung: **01.02.2017**
(21) Anmeldenummer: 05740065.7
(22) Anmeldetag: 22.04.2005
(51) Int. Cl.: G01R 31/42, G01R 31/00, G01R 31/02, H02P 9/24, H02J 7/14, H02P 29/024

(54) **GENERATORREGLER MIT DIAGNOSEFUNKTION FÜR HALBLEITERBAUELEMENTE**
GENERATOR REGULATOR WITH DIAGNOSTIC FUNCTION FOR SEMICONDUCTOR COMPONENTS
REGULATEUR DE GENERATRICE A FONCTION DIAGNOSTIQUE POUR DES COMPOSANTS SEMI-CONDUCTEURS

(30) Priorität: 09.06.2004 DE 102004028213
(43) Veröffentlichungstag der Anmeldung: 07.03.2007
(73) Patentinhaber: ROBERT BOSCH GMBH, 70442 Stuttgart (DE)
(72) Erfinder: NASSWETTER, Guenter, 72810 Gomaringen (DE)
(86) Internationale Anmeldenummer: PCT/EP2005/051794
(87) Internationale Veröffentlichungsnummer: WO 2005/122388

(56) Entgegenhaltungen:
- DE-A1- 3 104 121
- US-A1- 2003 006 740
- PATENT ABSTRACTS OF JAPAN Bd. 1996, Nr. 07, 31. Juli 1996 (1996-07-31) & JP 08 065914 A (NIPPONDENSO CO LTD), 8. März 1996 (1996-03-08)

## Beschreibung

### Technisches Gebiet

In Kraftfahrzeugen eingesetzte Generatoren wie z.B. Drehstromgeneratoren sind zur Gleichrichtung des Ausgangsstromes mit Dioden versehen. Mittels der Dioden werden alle drei Phasenanschlüsse U, V und W jeweils in Plusrichtung mit dem Pluspol der Fahrzeugbatterie und mit einer Diode in Sperrrichtung zur Masse verbunden. Zur Regelung der Ausgangsspannung von Drehstromgeneratoren werden elektronische Regler verwendet, die eine Information darüber benötigen, ob bzw. mit welcher Drehzahl der Generator arbeitet. Diese Drehinformation wird durch Beobachten eines oder mehrerer Phasenanschlüsse des Generators eingeholt.

### Stand der Technik

DE 43 08 769 A1 bezieht sich auf ein Verfahren zur Überwachung und/oder Schutz von Hochstromdioden. Bei dem aus DE 43 08 769 A1 bekannten Verfahren, welches insbesondere in Schweißanlagen eingesetzt wird, erfolgt die Überwachung der Hochstromdioden durch Bestimmung der Temperatur der Dioden, indem die Temperatur der Dioden analog, vorzugsweise mittels eines RC-Netzwerkes, elektrisch nachgebildet wird. Es wird ein Vergleich mit einem einer höchstzulässigen Temperatur der Hochstromdioden entsprechenden Referenzsignal durchgeführt. Zunächst wird der durch die Hochstromdioden fließende Strom erfasst, danach erfolgt ein Einprägen eines dem gemessenen Wert entsprechenden Stromes in eine Messleitung. Es wird eine Spannung erzeugt, welche das thermische Verhalten der Hochstromdiode unter Heranziehung eines RC-Netzwerkes darstellbar macht. Die nachgebildete Spannung wird mit einer vorgebbaren Referenzspannung ermittelt und im Falle der Überschreitung der vorgebbaren Referenzspannung durch die nachbildende Spannung wird ein Fehlersignal erzeugt. Eine Anordnung zur Durchführung des Verfahrens umfasst einen Strommesser, die den über die Hochstromdiode fließenden Strom misst und in ein Messsignal abbildet. Ferner umfasst die Anordnung eine gesteuerte Stromquelle, die einer Messleitung einen dem vom Strommesser abgegebenen Messsignal entsprechenden Strom einprägt sowie ein RC-Netzwerkblock, welcher der Messleitung eine das thermische Verhalten der Hochstromdiode nachbildende Spannung einprägt. Schließlich ist eine Überwachungsschaltung vorgesehen, die dann ein Signal abgibt, wenn die in die Messleitung eingeprägte Spannung einen vorgebbaren Referenzwert überschreitet.

Aus DE 100 05 183 A1 ist eine Gleichrichteranordnung bekannt. Diese Gleichrichteranordnung umfasst Halbleiter-Gleichrichterelemente zur Gleichrichtung einer an einem Eingang u, v, w der Gleichrichteranordnung anliegenden elektrischen Wechselgröße und einen Ausgang zum Abgreifen der gleichgerichteten elektrischen Größe. Zwischen den Gleichrichterelementen und dem Ausgang ist eine Schmelzsicherung geschaltet, wobei die Schmelzsicherung einen Halbleiterchip aus dem gleichen Halbleitermaterial wie die Gleichrichterelemente aufweist. Die Halbleiter-Gleichrichterelemente weisen Gleichrichter-Halbleiterchips auf, die von einem Gehäuse umgeben sind, wobei der Halbleiterchip der Schmelzsicherung von einem Gehäuse umgeben ist, das im Wesentlichen gleich aufgebaut ist wie die Gehäuse der Halbleiter-Gleichrichterelemente.

Ist eine der Dioden eines Drehstromgenerators defekt, sei es durch einen Kurzschluss, sei es durch eine Unterbrechung, kann der Generator nur noch einen reduzierten Ausgangsstrom liefern, so dass bei Zuschalten eines großen elektrischen Verbrauchers in das Bordnetz ein unzulässig hoher Spannungseinbruch auftreten kann. Zur Regelung der Ausgangsspannung eines Drehstromgenerators kommen in der Regel elektronische Regler zum Einsatz, die eine Information darüber benötigen, ob bzw. mit welcher Drehzahl der Generator betrieben wird. Diese Drehinformation wird durch Beobachten eines oder mehrerer der Phasenanschlüsse des Drehstromgenerators zur Verfügung gestellt. Die Frequenz der alternierenden Spannung ist direkt proportional zur Drehzahl des Drehstromgenerators.

Den genannten Verfahren bzw. Anordnungen und Vorrichtungen wohnt allesamt der Nachteile inne, dass im Regelfall die oben genannten Diodenfehler, d.h. deren Kurzschluss bzw. eine aufgetretene Unterbrechung entweder nicht oder nur unzureichend erkannt werden. Ferner ist gemäß der oben skizzierten Lösungen der konstruktive Aufwand zur Bereitstellung einer im Regler oder zur Unterbringung der Sensoren zu realisierende Aufwand im Regler erheblich, so dass stark erhöhte Herstellkosten die Folge sind.

Aus der US 2003/0006740 ist eine Vorrichtung zur Regelung des Erregerstromes für einen Drehstromgenerator bekannt. Sie weist eine Spannungsquelle, einen Gleichrichter, drei Phasenwicklungen, eine Auswerteeinheit und einen Spannungsregler auf. Die Auswerteeinheit weist drei Eingangsanschlüsse auf, wobei jeder dieser Eingangsanschlüsse mit einer der Phasenwicklungen verbunden ist. Die Auswerteeinheit ist zur Auswertung der von den drei Phasenwicklungen abgeleiteten Phasenspannungen vorgesehen, um Fehlfunktionen des Gleichrichters und/oder der Phasenwicklungen zu detektieren. Werden derartige unerlaubte Arbeitszustände detektiert, dann wird über den Spannungsregler der durch die Erregerwicklung fließende Erregerstrom reduziert.

### Darstellung der Erfindung

Mit dem Z gemäß Anspruch 1 vorgeschlagenen Verfahren kann durch Untersuchung nur eines Phasenanschlusses, so z.B. des Phasenanschlusses V, eine Detektion vorhandener Diodenfehler erfolgen. Diese detektierten Fehler können entweder dem Fahrer des Kraftfahrzeuges zur Anzeige gebracht werden oder im Fehlerspeicher eines Steuergerätes abgelegt werden, von wo aus sie mittels eines heute üblicherweise eingesetzten Diagnosesteckers ausgelesen werden. Auch kann durch gezieltes Abschalten bestimmter, für die Grundfunktion im Fahrzeug nicht unbedingt notwendiger Stromverbraucher ein Absinken der Spannung unter einen kritischen Wert verhindert werden.

Mit dem erfindungsgemäß vorgeschlagenen Verfahren lässt sich in vorausschauender Weise bereits dann einen Diodendefekt erkennen, bevor es aufgrund eines bei Diodenfehler vorliegenden reduzierten maximalen Ausgangsstroms des Generators zu einer Einschränkung des Betriebes oder zu Ladebilanzproblemen oder Komforieinschränkungen in Bezug auf das Bordnetz eines Kraftfahrzeuges kommt.

Die einzelnen Phasenanschlüsse eines Drehstromgenerators sind über die Generatorwicklungen niederohmig leitend miteinander verbunden. Bei Stillstand des Drehstromgenerators wird keine Spannung in diesen Wicklungen induziert. Da die eingesetzten Halbleiterbauelemente, im vorliegenden Falle Dioden, in Sperrrichtung üblicherweise hochohmig sind, ergibt sich an den Phasenanschlüssen ein Potential, welches von den Restströmen der Dioden und von der ohmschen Belastung an den Phasenanschlüssen des Drehstromgenerators abhängt. Im Betrieb wird jeweils in der positiven Halbwelle einer Phasenspannung die Plus- und in der negativen Halbwelle die Minus-Diode leitend

Im Fehlerfall eines Diodenkurzschlusses ist im Stillstand des Drehstromgenerators eine der gegen den Pluspol der Kfz-Batterie geschaltete Diode kurzgeschlossen oder niederohmig, so dass das Potential eines Phasenanschlusses im Stillstand auf Batteriespannungsniveau liegt und sich nicht wesentlich durch eine definierte geringe ohmsche Last an einem der Phasenanschlüsse des Drehstromgenerators absenken lässt. Ist hingegen eine gegen Masse geschaltete Diode kurzgeschlossen oder niederohmig, liegt das Potential entsprechend auf Masse und lässt sich nicht wesentlich durch Anlegen einer geringen ohmschen Last gegen den Pluspol der Kfz-Batterie erhöhen. In beiden Fällen kann der Fehler durch Beschalten mit einer beispielsweise als ohmschen Last beschaffenen Last gegen den Pluspol der KfzBatterie bzw. gegen Masse detektiert werden und ein Auswerten der sich dabei jeweils ergebenen Spannungspotentiale erfolgen.

Im Betrieb des Drehstromgenerators hingegen, bewirkt ein Kurzschluss einer Plus-Diode gegen den Pluspol der Kfz-Batterie an einem Phasenanschluss V, dass sich dort das Potential nicht mehr vom Pluspol der Kfz-Batterie unterscheidet. Ein Kurzschluss der Minus-Diode hingegen gegen Masse führt zu einem andauernd anliegenden Massepotential, so dass in beiden Fällen keine Drehzahlinformation gewonnen werden kann.

Ein Kurzschluss einer Plus-Diode an einem der anderen Phasenanschlüsse, z.B. U oder W, führt während der negativen Halbwelle der betroffenen Phase zu einem Spannungseinbruch am Pluspol der Kfz-Batterie, dieser Zweig Strom aufnimmt und damit den Ausgangsstrom reduziert. Ein Kurzschluss an der Minus-Diode des Drehstromgenerators an einem der anderen Phasenanschlüsse (U bzw. W) führt während der positiven Halbwelle der betroffenen Phase zu einem Spannungseinbruch, da in dieser Zeit kein Ausgangsstrom fließt

Im Falle einer Diodenunterbrechung an einem Phasenanschluss V wird die Spannung an diesem Anschluss während der positiven Halbwelle nicht mehr durch die Batterie bzw. das Bordnetz begrenzt und kann somit die Batteriespannung um mehrere Volt übersteigen. Ist hingegen die Minus-Diode des Phasenanschlusses V des Drehstromgenerators unterbrochen, wird die Spannung in der negativen Halbwelle nicht mehr durch die Masse begrenzt und kann somit das Massepotential um mehrere Volt unterschreiten.

Bei allen oben aufgeführten Fehlerarten ist ersichtlich, dass der von dem Fehler betroffene Phasenanschluss keinen Ausgangsstrom in das Bordnetz eines Kraftfahrzeuges beispielsweise abgeben kann. Aufgrund dessen wird während dieser Phase die Ausgangsspannung des Drehstromgenerators tiefer liegen als in den anderen Phasen.

### Zeichnung

Anhand der Zeichnung wird die Erfindung nachstehend eingehender beschrieben.

Es zeigt:
- Figur 1: die prinzipielle Anordnung eines Drehstromgenerators,
- Figur 2: den prinzipiellen Verlauf der Phasenspannungen einer elektrischen Maschine, wie z.B. eines Drehstromgenerators,
- Figur 3: die Auswirkung eines Kurzschlusses an der Plus-Diode am Phasenanschluss W,
- Figur 4: die Auswirkung eines Kurzschlusses an der Minus-Diode des Phasenanschlusses W,
- Figur 5: die Auswirkung einer Unterbrechung der Plus-Diode am Phasenanschluss W eines Drehstromgenerators,
- Figur 6: die Auswirkung einer Unterbrechung an einer Minus-Diode im Phasenanschluss W und
- Figur 7: die Auswirkung eines Diodenfehlers auf die Generatorausgangsspannung eines Drehstromgenerators.

### Ausführungsvarianten

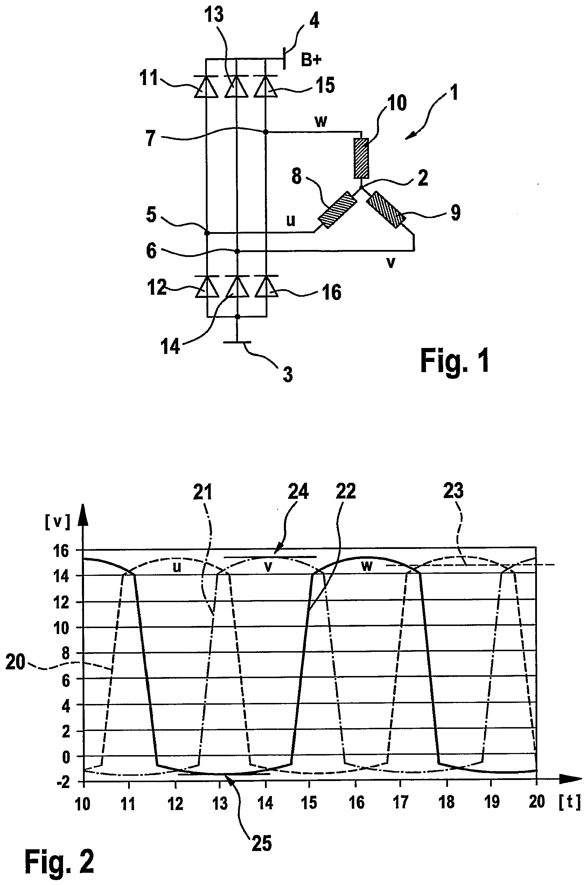

Der Darstellung gemäß Figur 1 ist der prinzipielle Aufbau eines Drehstromgenerators zu entnehmen.

Ein Drehstromgenerator 1, dessen U-Wicklung 8, dessen V-Wicklung 9 und dessen W-Wicklung 10 auf einen Generatorsternpunkt 2 geschaltet ist, weist Phasenanschlüsse für die Phasen U, V und W auf. Jede der Phasen U, V, W des Drehstromgenerators 1 ist an eine Leitung geschaltet, mit der eine in Flussrichtung wirkende Plus-Diode 11, 13 bzw. 15 auf genommen sind, sowie jeweils in Sperrrichtung wirkende Sperrdioden 12, 14 bzw. 16. Diese Leitungen sind einerseits sowohl mit einem Pluspol 4 einer Batterie (Potentialanschluss) verbunden als auch auf Masse 3 gelegt

Die einzelnen Phasenanschlüsse U, V, W sind über die Generatorwicklungen 8, 9 und 10 jeweils niederohmig leitend miteinander verbunden. Im Stillstand des Drehstromgenerators 1 wird keine Spannung in diesen Wicklungen 8, 9 und 10 induziert. Da die in Sperrrichtung wirkenden Halbleiterbauelemente 12, 14, 16, bei denen es sich bevorzugt um Dioden handelt, üblicherweise hochohmig ausgelegt sind, ergibt sich an den Phasenanschlüssen U, V, W ein Potential, das von den Restströmen der Halbleiterbauelemente 11, 13 und 15 sowie der ohmschen Belastung an den Phasenanschlüssen U, V, W abhängt Im Betrieb des Drehstromgenerators wird jeweils in der positiven Halbwelle einer Phasenspannung die Plus-Diode 11, 13 bzw. 15 leitend, während in der negativen Halbwelle einer Phasenspannung das in Sperrrichtung angeordnete Halbleiterbauelement 12, 14 bzw. 16 leitend wird.

Aus der Darstellung gemäß Figur 2 geht der prinzipielle Verlauf der Phasenspannungen in einem Drehstromgenerator hervor.

Die Verläufe der einzelnen Phasenspannungen 20, 21 bzw. 22 sind über die Zeit aufgetragen. Aus der Darstellung gemäß Figur 2 folgt, dass eine durch Bezugszeichen 23 identifizierte, Schwankungen unterworfene Bordnetzspannung 23 - abhängig von den einzelnen Spannungsmaxima 24 der Phasen U, V und W - aufrechterhalten wird. Entsprechend des 120°-Versatzes der Generatorwicklungen 8, 9 bzw. 10 stellt sich der in Figur 2 dargestellte Spannungsverlauf der einzelnen Phasen U, V und W des Drehstromgenerators 1 dar. Mit Bezugszeichen 20 ist der Verlauf der Phasenspannung U dargestellt, während mit Bezugszeichen 21 der Verlauf der Phasenspannung V in der Wicklung 9 des Drehstromgenerators 1 identifiziert ist. Bezugszeichen 22 markiert den Verlauf der Phasenspannung W, die in der Wicklung 10 des Drehstromgenerators 1 herrscht.

Die einzelnen Verläufe 20, 21, 22 der Spannungen U_{U}, U_{V} und Uw schwanken zwischen dem bereits erwähnten Spannungsmaximum 24 sowie einem jeweiligen Spannungsminimum 25 in der jeweiligen Phase U, V bzw. W. Die Darstellung der Spannungsverläufe gemäß Figur 2 spiegelt den Zustand wieder, in welchem bei dem in Figur 1 in schematischer Weise dargestellten Drehstromgenerator keine Defekte, so z.B. Kurzschlüsse oder Unterbrechungen, in den Phasenanschlüssen U, V, W zugeordneten Leitungen mit den dort in Flussrichtung wirkenden Halbleiterbauelementen 11, 13 bzw. 15 sowie den in Sperrichtung wirkenden Halbleiterbauelementen 12, 14 und 16 auftreten.

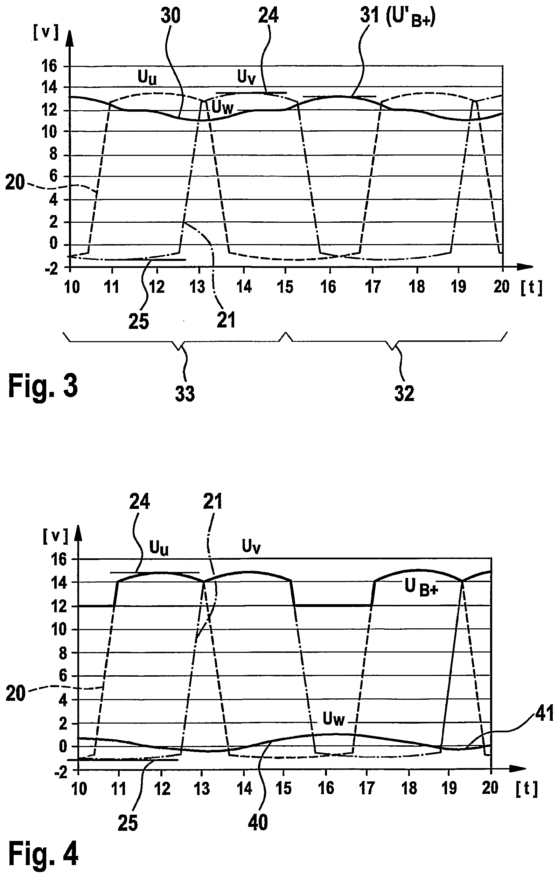

Der Darstellung gemäß Figur 3 und 4 sind die Auswirkungen von Kurzschlüssen an in Flussrichtung liegenden Halbleiterbauelementen des Drehstromgenerators zu entnehmen.

Ist eine der gegen den Pluspol 4 (B+) geschalteten Halbleiterbauelemente 11, 13 bzw. 15, bei denen es sich bevorzugt um Dioden handelt, kurzgeschlossen oder niederohmig, liegt das Potential im Stillstand des Drehstromgenerators 1 auf Batteriespannungsniveau und lässt sich nur unwesentlich durch Belastung mit einer definierten geringen ohmschen Last an einem der Phasenanschlüsse U, V, W absenken.

Ist hingegen ein gegen Masse 3 geschaltetes Halbleiterbauelement 12, 14 bzw. 16 kurzgeschlossen oder niederohmig, liegt das Potential entsprechend auf Potential des Masseanschlusses 3 und lässt sich nicht wesentlich durch Anlegen einer geringen ohmschen Last gegen den Pluspol 4 der Batterie (B+) erhöhen.

In beiden oben skizzierten Fällen, d.h. im Falle eines gegen den Pluspol 4 einer Fahrzeugbatterie geschalteten Halbleiterbauelementes 11, 13 bzw. 15 oder im Falle eines in Sperrrichtung geschalteten Halbleiterbauelementes 12, 14 bzw. 16 kann ein Kurzschluss des betreffenden Halbleiterbauelementes durch Beschalten eines Phasenanschlusses mit z.B. einer ohmschen Last gegen den Pluspol 4 einer Fahrzeugbatterie oder gegen den Anschluss an Masse 3 und eine sich daran anschließende Auswertung der sich dabei jeweils ergebenden Spannungspotentiale detektiert werden.

Während die oben dargestellte Detektion für den Fall eines stillstehenden Drehstromgenerators 1 geeignet ist, kann im Betrieb desselben einer der Phasenanschlüsse U, V, W, so z.B. der Phasenanschluss V, kurzgeschlossen sein. Im Betrieb des Drehstromgenerators bewirkt ein Kurzschluss des Halbleiterbauelementes 13 (Phasenanschluss V, wobei das Halbleiterbauelement 13 gegen den Pluspol 4 der Batterie liegt), dass sich das Potential nicht mehr von dem am Pluspol 4 der Kfz-Batterie (B+) anliegenden Potential unterscheidet. Ein Kurzschluss des in Sperrrichtung liegenden Halbleiterbauelementes 14 im Phasenanschluss V gegen das Potential der Masse 3 führt zu andauernd anliegendem Massepotential. Dies hat zur Folge, dass bei stets anstehendem Massepotential keine alternierende Spannung herrscht und demzufolge eine die Drehzahl des Drehstromgenerators 1 anzeigende Frequenz nicht vorliegt und demzufolge am Phasenanschluss V keine Drehzahlinformation gewonnen werden kann.

Die verbleibenden beiden Phasenanschlüsse U und W werden im Betrieb des Drehstromgenerators 1 auf das Auftreten eines Kurzschlusses an einem in Flussrichtung beschalteten Halbleiterbauelement 11 bzw. 15 während der negativen Halbwelle der jeweiligen Phase U oder W auf das Auftreten eines Spannungseinbruches am Pluspol 4 der Batterie (B+) hin untersucht. Die jeweiligen Phasen U bzw. W nehmen in diesem Falle Strom auf und reduzieren dadurch den Ausgangsstrom wie der Darstellung gemäß Figur 3 entnommen werden kann. Der Darstellung gemäß Figur 3 ist entnehmbar, dass beim Kurzschluss des Halbleiterbauelementes 15 die Phasenspannung W während der negativen Halbwelle 33 ein Minimum annimmt, in der Darstellung gemäß Figur 3 etwa 11 Volt. Das Maximum der Spannungen U_{U} bzw. U_{V} in den Phasen U und V ist durch Bezugszeichen 24 gekennzeichnet und liegt bei etwa 13,5 Volt, während das Potential, was am Pluspol 4 der Fahrzeugbatterie (B+) anliegt, d.h. die Batteriespannung, etwa bei 13 Volt liegt. Von Interesse sind die relativen Unterschiede der Spannungswerte zwischen den einzelnen Phasenanschlüssen.

Aus der Darstellung gemäß Figur 4 gehen die Auswirkungen eines Kurzschlusses des in Sperrrichtung liegenden Halbleiterbauelementes 16 hervor. Ein Kurzschluss eines in Sperrrichtung liegenden Halbleiterbauelementes 14 bzw. 16 in den Phasen U und W führt während einer positiven Halbwelle 32 der jeweils betroffenen Phase U oder W zu einem Spannungseinbruch, in Figur 4 durch Bezugszeichen 42 gekennzeichnet. Die Zurverfügungstellung eines Ausgangsstromes ist nicht möglich, da gemäß der Darstellung in Figur 4 das Maximum der Phasenspannung U, W (vgl. Bezugszeichen 40) abhängig vom Restwiderstand des Kurzschlusses lediglich wenige Volt beträgt, was erheblich unter der im Allgemeinen im Bordnetz eines Kraftfahrzeugs herrschenden Spannung von etwa 12 bzw. 24 Volt liegt.

Der Vollständigkeit halber sei erwähnt, dass die Maxima der jeweiligen Phasenspannungen U_{U} bzw. U_{V} durch Bezugszeichen 24 identifiziert sind und die Minima der jeweiligen Phasenspannungen U_{U} bzw. U_{V} durch Bezugszeichen 25 identifiziert sind.

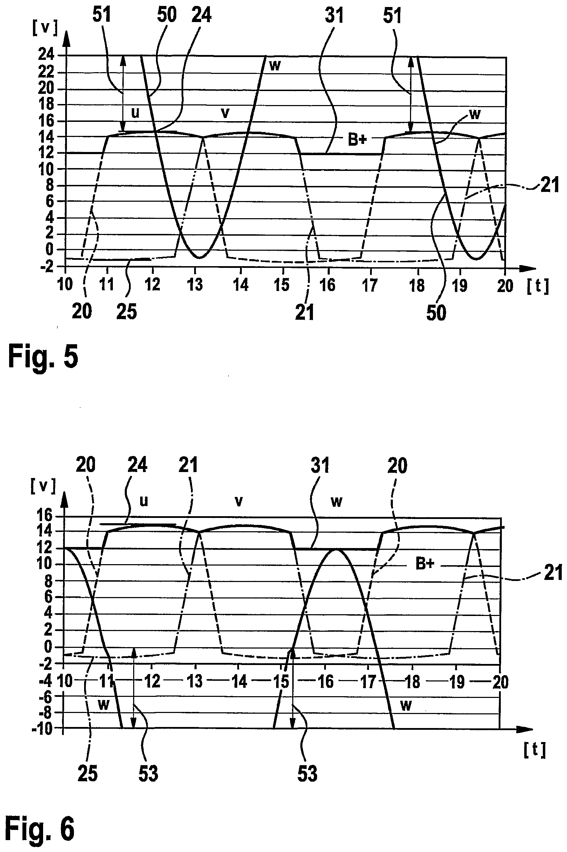

Im Falle des Fehlers einer Unterbrechung an einem Halbleiterbauelement 11, 12, 13, 14, 15 bzw. 16 in einem der Phasenanschlüsse U, V, W wird auf die Darstellungen gemäß Figur 5 und 6 verwiesen.

Ist ein in Flussrichtung liegendes Halbleiterbauelement 11, 13, 15 unterbrochen, so z.B. das Halbleiterbauelement 15 im Phasenanschluss V, wird die Spannung an diesem Anschluss während der positiven Halbwelle 32 nicht mehr durch die Fahrzeugbatterie bzw. das Bordnetz begrenzt und kann somit die am Pluspol 4 der Kfz-Batterie anliegende Spannung um mehrere Volt übersteigen, angedeutet durch den Lauf der Phasenspannung U, W gemäß Bezugszeichen 50. Die auftretende Spannungsüberhöhung ist durch Bezugszeichen 51 gekennzeichnet. Die Spannungserhöhung liegt erheblich über dem Spannungsmaximum 24 der Phasenspannung U_{U} gemäß des Verlaufes 20 der Phasenspannung U. Ist das in Sperrrichtung liegende Halbleiterbauelement 14 des Phasenanschlusses V hingegen unterbrochen, wird die Spannung während der negativen Halbwelle 33 nicht mehr durch das Potential des Masseanschlusses 3 begrenzt, so dass die Spannung U, W für diesen Fall gemäß des in Figur 6 eingetragenen Spannungsverlaufes 52 für die Phasenspannung U, W das Massepotential um mehrere Volt unterschreiten kann, angedeutet durch den Spannungsabfall 53 gemäß der Darstellung in Figur 6.

Sind die in Flussrichtung liegenden Halbleiterbauelemente 11 bzw. 15 sowie die in Sperrrichtung liegenden Halbleiterbauelemente 12 bzw. 16 der Phasenanschlüsse U und W unterbrochen, können die jeweils mit einer Unterbrechung behafteten Phasen U oder W ebenfalls keinen Strom ins Bordnetz eines Kraftfahrzeuges abgeben.

Allen dargestellten Fehlerarten, sei es aufgetretene Kurzschlüsse im Bereich der in Flussrichtung liegenden Halbleiterbauelemente 11, 13, 15 oder bei in Sperrrichtung liegenden Halbleiterbauelementen 12, 14, 16 sowie bei Unterbrechungen an den Halbleiterbauelementen, ist gemeinsam, dass der von dem Fehler jeweils betroffene Phasenanschluss U oder V oder W keinen Ausgangsstrom in das Bordnetz abgeben kann. Aufgrund dieses Umstandes liegt während der jeweiligen Phase U, V oder W die Ausgangsspannung des Drehstromgenerators tiefer als in den anderen, intakten Phasen.

Die Fehlerdetektion sei anhand des Phasenanschlusses V beschrieben. Ist die direkt beobachtete, d.h. gemessene, Phase V betroffen, ist sowohl im Stillstand des Drehstromgenerators 1 als auch im Betrieb desselben, eine einfache Auswertung des fehlerbehafteten Verhaltens möglich. Im Stillstand des Drehstromgenerators 1 wird der Phasenanschluss V z.B. mittels eines wohldefinierten Lastwiderstandes gegen Masse 3 bzw. gegen den Pluspol 4 der Fahrzeugbatterie (B+) belastet. Ergeben sich dabei deutlich vom Potential des Masseanschlusses 3 bzw. vom Potential des Pluspoles 4 der Kraftfnhrzeugbatterie (B+) verschiedene Potentiale, kann auf einen Kurzschluss mindestens eines Halbleiterbauelementes 11, 13, 15 gegen den Pluspol 4 der Batterie oder auf den Kurzschluss eines Halbleiterbauelementes 12, 14, 16 auf das Potential des Masseanschlusses 3 geschlossen werden.

Im Betrieb des Drehstromgenerators wird die Phasenspannung U_{V} in der Phase V im Falle eines aufgetretenen Kurzschlusses fest auf dem Potential des Pluspoles 4 der Kfz-Batterie (B+) oder auf dem Potential des Masseanschlusses 3 liegen und somit mangels einer Frequenz einer alternierenden Spannung eine Frequenzauswertung nicht zulassen.

Eine Unterbrechung eines Halbleiterbauelementes - in Bezug auf die Phase V, das Halbleiterbauelement 13 oder 14 - führt wie oben stehend angegeben zu einfach zu detektierenden Spannungsverläufen, die gemäß den Darstellungen in Figur 5 und 6 entweder deutlich über dem Potential des Pluspoles 4 einer Kfz-Batterie verlaufen oder sich deutlich unterhalb des Potentials des Masseanschlusses 3 bewegen (vgl. Bezugszeichen 51 in Figur 5 und Bezugszeichen 53 gemäß Figur 6).

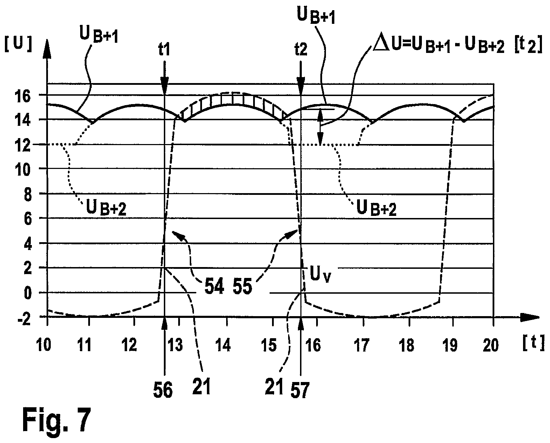

Bei Beobachtung der Phase V kann in den verbleibenden Phasen U, W je nach aufgetretenem Fehlerort entweder in Phase U oder in Phase W kein Ausgangsstrom während der positiven Halbwelle 32 der jeweils betroffenen Phase U, W fließen, so dass sich eine in Figur 7 dargestellte reduzierte Ausgangsspannung 58 bzw. 59 einstellt.

Da eine ansteigende Flanke 54 der Phasenspannung U_{V} der Phase V bzw. eine fallende Flanke 55 der Phasenspannung U_{V} in der Phase V mit der positiven Halbwelle 32 der Phasenspannungsverläufe 20 bzw. 22 zusammenfällt, kann zu festgelegten Zeitpunkten t₁ bzw. t₂ der steigenden Flanke 54 und der fallenden Flanke 55 der Spannung U_{V} (vgl. Bezugszeichen 21 in Figur 7) die Spannung U_{B+1}, bzw. U_{B+2} am Pluspol 4 der Kfz-Batterie (B+) erfasst werden. Die erfassten Spannungen können einem Vergleich unterzogen werden. Für den Fall, dass sich während einer Vielzahl aufeinanderfolgender Detektionszeitpunkte ein Unterschied zwischen den zu den Detektionszeitpunkten t₁ (56), t₂ (57) jeweils erfassten Spannungen U_{B+1}, U_{B+2} ergibt, die größer als ein festgelegter Grenzwert ist, kann auf einen Defekt eines Halbleiterbauelementes zurückgeschlossen werden. Mit U_{B+1} ist der Spannungsverlauf in der Phase W bezeichnet, der mit dem Batteriespannungsniveau zusammenfällt, für den Fall, dass in der Phase W kein Fehler in Gestalt des Versagens eines Halbleiterbauelementes aufgetreten ist. Mit U_{B+2} ist der Spannungsverlauf in der Phase W dargestellt, für den Fall, dass in der Phase W ein Fehler aufgetreten ist. Es stellt sich demzufolge in der Phase W ein im Vergleich zu einer unbeschädigten Phase W geringere Ausgangsspannung ein ΔU = U_{B+1}-U_{B+2} (t₂). Die gemessene Phase ist die Phase V.

In analoger Weise kann zum Zeitpunkt t₁ (Bezugszeichen 56) ein Vergleich der Spannungen in der Phase U vorgenommen werden, bei dem - wie oben stehend beschrieben - ebenfalls ein Vergleich der Phasenspannungen in der Phase U erfolgen kann, aus dessen Resultat in analoger Weise auf einen Fehler in der Phase U zurückgeschlossen werden kann. Der Spannungsverlauf in der Phase W ist in der Darstellung gemäß Figur 7 gestrichelt dargestellt, während der durch U_{B+1} vorliegende Spannungsverlauf in der Phase W mit durchgezogener Linie dargestellt ist.

In vorteilhafter Weise kann das erfindungsgemäß vorgeschlagene Verfahren zur Fehlerdetektion in Halbleiterbauelementen 11, 12, 13, 14, 15, 16 an einem Drehstromgenerator bei geringen Drehzahlen und Generatorlast desselben durchgeführt werden. Bei hohen Drehzahlen des Drehstromgenerators 1 und bei hohen Lasten auftretende Welligkeiten der Drehstromgeneratorausgangsspannungen beeinflussen durch das Rückwärtserhol-Verhalten der Halbleiterbauelemente 11, 12, 13, 14, 15 und 16 die. Detektion eines Spannungsunterschiedes. Ferner ist die externe Beschaltung des Bordnetzes bei einer Vielzahl von eingeschalteten elektrischen Verbrauchern auf die Detektion eines Spannungsunterschiedes ΔU zu berücksichtigen.

Zur Übermittlung des detektieren Fehlers kann eine Fehleranzeige eingeschaltet werden. Ferner besteht die Möglichkeit, ein Fehlerflag zu setzen, welches über eine (Daten)schnittstelle von einem Steuergerät ausgelesen werden kann. Andererseits ist es auch möglich, zur Übermittlung des Fehlers diesen aktiv über eine Schnittstelle auszugeben. Das erfindungsgemäß vorgeschlagene und vorstehend beschriebene Verfahren bietet die Möglichkeit, einen Defekt eines Halbleiterbauelementes 11, 12, 13, 14, 15, 16 bereits frühzeitig zu erkennen, noch bevor es aufgrund des reduzierten maximalen Ausgangsstromes des Drehstromsgenerators zu einer Einschränkung des Betriebes des Bordnetzes oder zu Ladebilanzproblemen in Bezug auf die Fahrzeugbatterie oder zu Komforteinschränkungen kommen kann.

### Bezugszeichenliste

- 1: Drehstromgenerator
- 2: Generatorsternpunkt
- 3: Anschluss Massepotential
- 4: Anschluss Pluspol Batterie (B+)
- 5: U-Phasenanschluss
- 6: V-Phasenanschluss
- 7: W-Phasenanschluss
- 8: U-Wicklung
- 9: V-Wicklung
- 10: W-Wicklung
- 11: U-Plusdiode
- 12: U-Sperrdiode
- 13: V-Plusdiode
- 14: V-Sperrdiode
- 15: W-Plusdiode
- 16: W-Sperrdiode

- 20: Verlauf Phasenspannung U
- 21: Verlauf Phasenspannung V
- 22: Verlauf Phasenspannung W
- 23: Bordnetzspannung
- 24: Spannungsmaxima pro Phase
- 25: Spannungsminima pro Phase

- 30: Kurzschlussspannung U_{W} (Plusdiode)
- 31: Batteriespannung U_{B+}
- 32: positive Halbwelle
- 33: negative Halbwelle

- 40: Kurzschlussspannung U_{W} (Sperrdiode)
- 41: Massepotential
- 42: Spannungseinbruch

- 50: Phasenspannung U_{W} bei Unterbrechung (Plusdiode)
- 51: Spannungsüberhöhung
- 52: Phasenspannung U_{W} bei Unterbrechung (Minus-Diode)
- 53: Spannungsabfall
- 54: ansteigende Flanke Phasenspannung U_{V},
- 55: fallende Flanke Phasenspannung U_{V}
- 56: erster Zeitpunkt (t₁)
- 57: zweiter Zeitpunkt (t₂)
- U_{B+1}: Ausgangsspannung ohne Fehler in Phase W
- U_{B+2}: Ausgangsspannung mit Fehler in Phase W

## Patentansprüche

1. Verfahren zur Fehlerdetektion von Halbleiterbauelementen (11, 12, 13, 14, 15, 16) in elektrischen Maschinen (1), insbesondere Drehstromgeneratoren mit mehreren Wicklungen (8, 9, 10) und mehreren Phasenanschlüssen U, V, W mit nachfolgenden Verfahrensschritten:
a) bei Stillstand der elektrischen Maschine (1) erfolgt zur Erkennung von Kurzschlüssen gegen B+ oder Masse die Belastung eines der Phasenanschlüsse U, V, W gegen Masse (3) oder gegen ein höheres Potential (4) und eine Messung des sich einstellten Potentials,
b) im Betrieb der elektrischen Maschine (1) erfolgt zur Erkennung von Kurzschlüssen gegen B+ oder Masse die Messung einer der Spannungen U_{U}, Uv, Uw in einem der Phasenanschlüsse U, V, W auf Übereinstimmung mit Massepotential (3) oder dem Potential (4),
c) im Betrieb der elektrischen Maschine (1) erfolgt zur Erkennung von Unterbrechungen die Messung einer der Spannungen U_{U}, U_{V}, U_{W} in einem der Phasenanschlüsse U, V, W auf Unter- bzw. Überschreitung eines definierten Minimal- bzw. Maximalwertes und
d) zu definierten Zeitpunkten t₁, t₂ von steigenden und fallenden Flanken (54, 55) der gemessenen Spannung (21) im gemessenen Phasenanschluss werden die jeweiligen Spannungen am Anschluss (4) des Potentials erfasst und die beiden Werte miteinander verglichen.

2. Verfahren gemäß Anspruch 1, **dadurch gekennzeichnet, dass** die Fehlerdetektion bei geringen Drehzahlen und geringen Lasten des Drehstromgenerators durchgeführt wird.

3. Verfahren gemäß Anspruch 1, **dadurch gekennzeichnet, dass** die nicht gemessenen Phasenanschlüsse U, W der Phasenanschlüsse U, V, W während der positiven Halbwelle (32) auf reduzierte Ausgangsspannungen (58, 59) überprüft werden.

4. Verfahren gemäß Anspruch 1, **dadurch gekennzeichnet, dass** die Erfassung der jeweiligen Spannung am Anschluss (4) des Potentials über eine Vielzahl aufeinanderfolgender Detektionszeitpunkte erfolgt.

5. Verfahren gemäß Anspruch 1, **dadurch gekennzeichnet, dass** gemäß Verfahrensschritt b) zur Fehlerdetektion eines in Flussrichtung liegenden Halbleiterbauelementes (11, 13, 15) in den weiteren Phasenanschlüssen U, W diese während der negativen Halbwelle (33) im gemessenen Phasenanschluss V auf einen Spannungseinbruch am Anschluss (4) des Potentials überprüft werden.

6. Verfahren gemäß Anspruch 1, **dadurch gekennzeichnet, dass** gemäß Verfahrensschritt b) zur Fehlerdetektion eines in Sperrrichtung liegenden Halbleiterbauelementes (12, 14, 16) die weiteren Phasenanschlüsse U, W während der positiven Halbwelle (32) im gemessenen Phasenanschluss V auf einen Spannungseinbruch überprüft werden.

7. Verfahren gemäß Anspruch 1, **dadurch gekennzeichnet, dass** gemäß Verfahrensschritt c) die über die nicht gemessen Phasenanschlüsse U, W fließenden Ausgangsströme ermittelt werden.

## Claims

1. Method for detecting faults in semiconductor components (11, 12, 13, 14, 15, 16) in electric machines (1), in particular three-phase generators having a plurality of windings (8, 9, 10) and a plurality of phase terminals U, V, W, comprising the following method steps:
a) when the electric machine (1) is at a standstill, in order to identify short circuits relative to B+ or earth, one of the phase terminals U, V, W is loaded relative to earth (3) or relative to a higher potential (4) and the potential established is measured,
b) during the operation of the electric machine (1), in order to identify short circuits relative to B+ or earth, one of the voltages U_{U}, Uv, Uw in one of the phase terminals U, V, W is measured in respect of correspondence to earth potential (3) or the potential (4),
c) during the operation of the electric machine (1), in order to identify interruptions, one of the voltages U_{U}, Uv, Uw in one of the phase terminals U, V, W is measured in respect of undershooting or exceeding a defined minimum or maximum value, respectively, and
d) at defined instants t₁, t₂ of rising and falling edges (54, 55) of the measured voltage (21) in the measured phase terminal, the respective voltages at the terminal (4) of the potential are detected and the two values are compared with one another.

2. Method according to Claim 1, **characterized in that** the fault detection is carried out at low rotational speeds and low loads of the three-phase generator.

3. Method according to Claim 1, **characterized in that** the non-measured phase terminals U, W of the phase terminals U, V, W are checked during the positive half-cycle (32) in respect of reduced output voltages (58, 59).

4. Method according to Claim 1, **characterized in that** the respective voltage at the terminal (4) of the potential is detected over a multiplicity of successive detection instants.

5. Method according to Claim 1, **characterized in that** in accordance with method step b) for detecting a fault in a semiconductor component (11, 13, 15) disposed in the forward direction, in the further phase terminals U, W, the latter are checked during the negative half-cycle (33) in the measured phase terminal V in respect of a voltage dip at the terminal (4) of the potential.

6. Method according to Claim 1, **characterized in that** in accordance with method step b) for detecting a fault in a semiconductor component (12, 14, 16) disposed in the reverse direction, the further phase terminals U, W are checked during the positive half-cycle (32) in the measured phase terminal V in respect of a voltage dip.

7. Method according to Claim 1, **characterized in that** in accordance with method step c), the output currents flowing via the non-measured phase terminals U, W are determined.

## Revendications

1. Procédé de détection de défaut de composants semiconducteurs (11, 12, 13, 14, 15, 16) dans des machines électriques (1), notamment des générateurs de courant alternatif pourvus de plusieurs enroulements (8, 9, 10) et de plusieurs bornes de phase U, V, W, comprenant les étapes suivantes :
a) lors de l'immobilisation de la machine électrique (1), en vue de détecter les courts-circuits par rapport à B+ ou la masse, l'une des bornes de phase U, V, W est mise en charge par rapport à la masse (3) ou par rapport à un potentiel plus élevé (4) et le potentiel qui s'établit est mesuré,
b) pendant le fonctionnement de la machine électrique (1), en vue de détecter les courts-circuits par rapport à B+ ou la masse, l'une des tensions U_{U}, Uv, Uw dans l'une des bornes de phase U, V, W est mesurée pour vérifier si elle coïncide avec le potentiel de masse (3) ou le potentiel (4),
c) pendant le fonctionnement de la machine électrique (1), en vue de détecter les interruptions, l'une des tensions U_{U}, Uv, U_{W} dans l'une des bornes de phase U, V, W est mesurée pour vérifier si elle est inférieure ou supérieure à une valeur minimale ou maximale définie,
d) à des instants t₁, t₂ définis de fronts montants et descendants (54, 55) de la tension mesurée (21) dans la borne de phase mesurée, les tensions respectives sont détectées à la borne (4) du potentiel et les deux valeurs sont comparées entre elles.

2. Procédé selon la revendication 1, **caractérisé en ce que** la détection de défaut est effectuée aux faibles vitesses de rotation et aux faibles charges du générateur de courant alternatif.

3. Procédé selon la revendication 1, **caractérisé en ce que** les bornes de phase non mesurées U, W des bornes de phase U, V, W sont soumises à un contrôle pendant la demi-onde positive (32) pour vérifier si elles présentent des tensions de sortie (58, 59) réduites.

4. Procédé selon la revendication 1, **caractérisé en ce que** la détection de la tension respective au niveau de la borne (4) du potentiel s'effectue par le biais d'une pluralité d'instants de détection successifs.

5. Procédé selon la revendication 1, **caractérisé en ce que** selon l'étape de procédé b), en vue de la détection de défaut d'un composant semiconducteur (11, 13, 15) qui se trouve dans le sens du passage dans les autres bornes de phase U, W, celles-ci sont soumises à un contrôle pendant la demi-onde négative (33) dans la borne de phase mesurée V pour vérifier si elles présentent une chute de tension au niveau de la borne (4) du potentiel.

6. Procédé selon la revendication 1, **caractérisé en ce que** selon l'étape de procédé b), en vue de la détection de défaut d'un composant semiconducteur (12, 14, 16) qui se trouve dans le sens du blocage, les autres bornes de phase U, W sont soumises à un contrôle pendant la demi-onde positive (32) dans la borne de phase mesurée V pour vérifier si elles présentent une chute de tension.

7. Procédé selon la revendication 1, **caractérisé en ce que** selon l'étape de procédé c), les courants de sortie qui circulent sur les bornes de phase U, W non mesurées sont déterminés.
